# EUROPEAN PATENT APPLICATION

(11) **EP 4 629 270 A1**
(43) Date of publication of application: **08.10.2025**
(21) Application number: 25166836.4
(22) Date of filing: 27.03.2025
(51) Int. Cl.: H01G 4/224, H05K 7/14, H01G 2/04, H01G 4/228, H01G 4/38, H01G 4/40, H02M 7/00, H01G 2/10

(54) **SYSTEMS AND METHODS FOR CAPACITOR LEADFRAME FOR POWER CONVERTER FOR ELECTRIC VEHICLE**

(30) Priority: 05.04.2024 US 202463575233 P; 26.03.2025 US 202519091113
(71) Applicant: BorgWarner Luxembourg Automotive Systems S.A., 4940 Bascharage (LU)
(72) Inventor: HERVE, Sebastien, Audun-le-Tiche (FR); UMLAUFF, Alexander, Framersheim (DE); GRUNDMEIER, Juergen, Argenschwang (DE)
(74) Representative: Office Freylinger

(57) **Abstract**

A system includes a power converter including a capacitor leadframe including: one or more capacitors; a carrier supporting the one or more capacitors; a first lead to connect the one or more capacitors to a first connector; a second lead to connect the one or more capacitors to a second connector; and one or more third leads to connect the one or more capacitors to a ground connector.

## Description

### CROSS-REFERENCE TO RELATED APPLICATION(S)

This application claims the benefit of priority to U.S. Provisional Patent Application No. 63/575,233, filed April 5, 2024, the entirety of which is incorporated by reference herein.

### TECHNICAL FIELD

Various embodiments of the present disclosure relate generally to a capacitor leadframe and, more particularly, to a capacitor leadframe for one or more capacitors in a power converter for an electric vehicle.

### BACKGROUND

EMC filters are used to suppress interference, such as for high voltage direct current (HVDC) inputs of high voltage (HV) products, such as inverters, for example. Capacitors may be used as an interference suppression measure for differential noise between the DC positive and DC negative terminals of the battery and for common mode noise between all conductors and ground. EMC filters may be provided on a circuit board, which may increase a complexity and a component count of a system.

The present disclosure is directed to overcoming one or more of these above-referenced challenges.

### SUMMARY OF THE DISCLOSURE

In some aspects, the techniques described herein relate to a system including a power converter including: a capacitor leadframe including: one or more capacitors; a carrier supporting the one or more capacitors; a first lead to connect the one or more capacitors to a first connector; a second lead to connect the one or more capacitors to a second connector; and one or more third leads to connect the one or more capacitors to a ground connector.

In some aspects, the techniques described herein relate to a system, wherein the one or more capacitors are configured to filter noise between a positive terminal of a battery and a negative terminal of the battery.

In some aspects, the techniques described herein relate to a system, wherein the one or more capacitors are configured to filter noise between a conductor and a ground.

In some aspects, the techniques described herein relate to a system, wherein the first lead, the second lead, and the one or more third leads extend in an outward direction from the carrier.

In some aspects, the techniques described herein relate to a system, wherein the first lead, the second lead, and the one or more third leads are connected via one or more of pins, clamps, or solder.

In some aspects, the techniques described herein relate to a system, wherein the capacitor leadframe further includes a cover.

In some aspects, the techniques described herein relate to a system, wherein the first connector is for a positive terminal of a power source, and the second connector is for a negative terminal of the power source.

In some aspects, the techniques described herein relate to a system, further including: a battery configured to provide DC power to the power converter; and a motor configured to receive AC power from the power converter to drive the motor, wherein the system is provided as a vehicle including the power converter, the battery, and the motor.

In some aspects, the techniques described herein relate to a capacitor leadframe for a power converter, the capacitor leadframe including: a carrier for one or more capacitors; a first lead to connect the one or more capacitors to a first connector; a second lead to connect the one or more capacitors to a second connector; and one or more third leads to connect the one or more capacitors to a ground connector.

In some aspects, the techniques described herein relate to a capacitor leadframe, wherein the first connector is for a positive terminal of a power source, and the second connector is for a negative terminal of the power source.

In some aspects, the techniques described herein relate to a capacitor leadframe, wherein the capacitor leadframe further includes a cover to connect to the carrier.

In some aspects, the techniques described herein relate to a capacitor leadframe, wherein one or more of the cover or the carrier are configured to support the one or more capacitors.

In some aspects, the techniques described herein relate to a capacitor leadframe, wherein the first lead, the second lead, and the one or more third leads extend from the carrier.

In some aspects, the techniques described herein relate to a capacitor leadframe, wherein the one or more capacitors include one or more first capacitors to suppress noise between the first connector and the second connector, and one or more second capacitors to suppress noise between conductors and the ground connector.

In some aspects, the techniques described herein relate to a capacitor leadframe, wherein the one or more first capacitors are configured to be arranged between the one or more second capacitors and the carrier.

In some aspects, the techniques described herein relate to a capacitor leadframe assembly including: one or more capacitors; a carrier for the one or more capacitors; a first lead extending from the carrier to electrically connect the one or more capacitors to a first connector; a second lead extending from the carrier to electrically connect the one or more capacitors to a second connector; and one or more third leads extending from the carrier to electrically connect the one or more capacitors to a ground connector.

In some aspects, the techniques described herein relate to a capacitor leadframe assembly, further including: a cover connected to the carrier, wherein the one or more capacitors are arranged horizontally in the carrier between the carrier and the cover.

In some aspects, the techniques described herein relate to a capacitor leadframe assembly, wherein the one or more capacitors are arranged vertically in the carrier.

In some aspects, the techniques described herein relate to a capacitor leadframe assembly, wherein the one or more capacitors include: a first capacitor and a second capacitor, the first capacitor and the second capacitor configured to filter common mode noise to the ground connector, and a third capacitor to filter differential noise between the first connector and the second connector.

In some aspects, the techniques described herein relate to a capacitor leadframe assembly, wherein the first capacitor and the second capacitor are arranged between the third capacitor and the carrier.

Additional objects and advantages of the disclosed embodiments will be set forth in part in the description that follows, and in part will be apparent from the description, or may be learned by practice of the disclosed embodiments. The objects and advantages of the disclosed embodiments will be realized and attained by means of the elements and combinations particularly pointed out in the appended claims.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including a power converter, according to one or more embodiments.
FIG. 2 depicts an exemplary system infrastructure for a power converter, according to one or more embodiments.
FIG. 3 depicts an exemplary power converter with a capacitor leadframe assembly, according to one or more embodiments.
FIG. 4A depicts an isometric view of a capacitor leadframe assembly with a cover, according to one or more embodiments.
FIG. 4B depicts a top view of a capacitor leadframe assembly with a cover, according to one or more embodiments.
FIG. 4C depicts an exploded view of a capacitor leadframe assembly with a cover, according to one or more embodiments.
FIG. 4D depicts an exemplary power converter with a capacitor leadframe assembly with a cover, according to one or more embodiments.
FIG. 5A depicts an isometric view of a soldered capacitor leadframe assembly, according to one or more embodiments.
FIG. 5B depicts a top view of a soldered capacitor leadframe assembly, according to one or more embodiments.
FIG. 5C depicts an exploded view of a soldered capacitor leadframe assembly, according to one or more embodiments.
FIG. 5D depicts an exemplary power converter with a soldered capacitor leadframe assembly, according to one or more embodiments.
FIG. 6A depicts an exemplary power converter with an XY capacitor leadframe assembly, according to one or more embodiments.
FIG. 6B depicts an XY capacitor leadframe, according to one or more embodiments.
FIG. 6C depicts an exploded view of an XY capacitor leadframe assembly, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section. For example, in the context of the disclosure, switching devices may be described as switches or devices, but may refer to any device for controlling the flow of power in an electrical circuit. For example, switches may be metal-oxide-semiconductor field-effect transistors (MOSFETs), bipolar junction transistors (BJTs), insulated-gate bipolar transistors (IGBTs), or relays, for example, or any combination thereof, but are not limited thereto.

Various embodiments of the present disclosure relate generally to a capacitor leadframe and, more particularly, to a capacitor leadframe for one or more capacitors in a power converter for an electric vehicle. Inverters, such as those used to drive a motor in an electric vehicle, for example, are responsible for converting High Voltage Direct Current (HVDC) into Alternating Current (AC) to drive the motor. A three phase inverter may include a bridge with six power device switches (for example, power transistors such as IGBT or MOSFET) that are controlled by Pulse Width Modulation (PWM) signals generated by a controller. An inverter may include three half-H bridge switches to control the phase voltage, upper and lower gate drivers to control the switches, a PWM controller, and glue logic between the PWM controller and the gate drivers. The PWM controller may generate signals to define the intended states of the system. The gate drivers may send the signals from the PWM controller to the half-H bridge switches. The half-H bridge switches may drive the phase voltage. Six phase (or other phase) inverters, chargers, DC-DC converters, and/or multi-level inverters are not excluded from this concept and will follow similar principles. The present disclosure refers to an inverter as an example embodiment of a power converter. Power converters may include chargers, inverters, or DC-DC converters, for example.

High voltage direct current (HVDC) inputs of high voltage (HV) products, such as inverters, use electromagnetic compatible (EMC) filters to suppress interference. A capacitor may be used as an interference suppression measure for differential noise between the HVDC positive and HVDC negative terminals of the HV battery. A capacitor may be used as an interference suppression measure for common mode noise between all conductors and the ground potential. These capacitors (e.g., X and Y) may be soldered onto a printed circuit board (PCB) (e.g., surface-mount device (SMD)) called HVDC Filter Boards. The capacitors may be surface-mount (SMT) ceramic capacitors (e.g., MOSFET). A disadvantage of using a PCB in the HVDC filter board may be the increased complexity and component count, which may be associated with high costs.

One or more embodiments may lower complexity and component count, which may lower costs associated with using a PCB HVDC filter board, by replacing the HVDC filter board with a capacitor leadframe. A capacitor leadframe may connect the positive and negative HVDC terminals to the chassis inverter ground potential via conductor tracks of a stamped grid, which may be held and fixed by an electrically non-conductive carrier. One or more capacitors may be arranged on the connecting conductor track to be held and fixed in the electrically non-conductive carrier. The electrical connection between the conductor track and the one or more capacitors may be achieved using either soldering or clamping. An advantage may be that the assembled PCB HVDC filter board can be completely replaced by the capacitor leadframe. Additional advantages may include one or more of the following: the use of lower cost Stick Lead capacitors, removing FR4 PCB material, a larger range of capacitors may be used, no soldering may be required using a clamped connection, the assembly process may be simplified at the manufacturing plant, or a cost reduction of the inverter product for the HVDC filter building block. Additional advantages may include flexibility in the number and size of the X and Y capacitors required. Advantages may include flexibility of the fastener positions, which can only be achieved on the circuit board by additional soldered copper conductors, especially when the fastener positions are on different levels, parallel, or angled.

Some inverters may include an HVDC positive terminal, an HVDC negative terminal, an HVDC filter board, and a chassis with ground. The HVDC filter board may connect the HVDC positive and HVDC negative terminals to the chassis with ground. Some HVDC filter boards may include one or more capacitors, a filter board, a resistor, and a filter. One or more embodiments may provide a capacitor leadframe that does not include a filter board, a resistor, or a filter.

One or more embodiments may include a clamped electrical connection. The clamped electrical connection may include an IDT pin connection also serving as an assembly tool. One or more embodiments may include a soldered electrical connection. The soldered electrical connection may include a simplified capacitor leadframe, carrier, and/or soldering of leads.

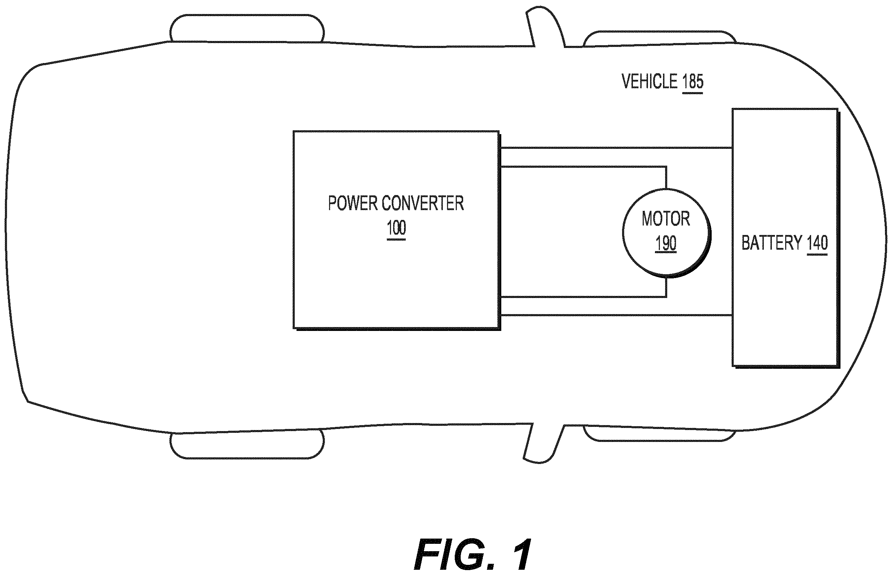

FIG. 1 depicts an exemplary system infrastructure for a vehicle including a power converter, according to one or more embodiments. The power converter 100 may be a combined inverter and converter. Alternatively, the inverter may be an inverter without a converter. In the context of this disclosure, a battery charger, the inverter, the converter, or any combination thereof may be referred to as power converter 100. Electric vehicle 185 may include power converter 100, motor 190, and battery 140. Power converter 100 may include components to receive electrical power from an external source and output electrical power to charge battery 140 of electric vehicle 185. Power converter 100 may convert DC power from battery 140 in electric vehicle 185 to AC power, to drive motor 190 of the electric vehicle 185, for example, but the embodiments are not limited thereto. For example, power converter 100 may include components to receive electrical power from an external source and output electrical power to charge battery 140 without motor 190 connected to power converter 100. Power converter 100 may convert DC power from battery 140 in electric vehicle 185 to AC power, to drive AC components other than motor 190 of the electric vehicle 185. Power converter 100 may be bidirectional, and may convert DC power to AC power, or convert AC power to DC power, such as during regenerative braking, for example. Power converter 100 may be a three-phase inverter, a single-phase inverter, or a multi-phase inverter.

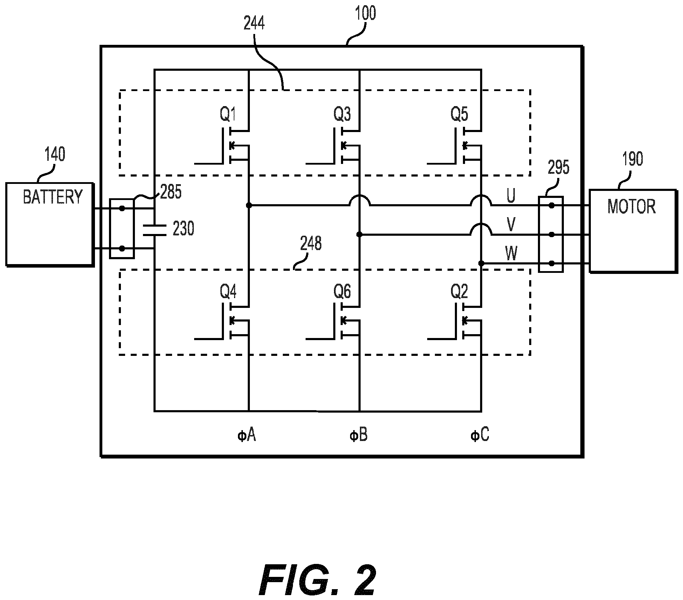

FIG. 2 depicts an exemplary system infrastructure for a power converter, according to one or more embodiments. Power converter 100 may be used to convert DC power from a battery in electric vehicle 185 to AC power, to drive motor 190 of electric vehicle 185, for example, but embodiments are not limited thereto. Additionally, power converter 100 may be bidirectional, and used to convert DC power to AC power, or to convert AC power to DC power.

Power converter 100 may be connected to battery 140 and motor 190. Power converter 100 may include upper phase switches 244 and lower phase switches 248. A first phase (ΦA) may include switches Q1 and Q4, a second phase (ΦB) may include switches Q3 and Q6, and a third phase (ΦC) may include switches Q5 and Q2. Upper phase switches 244 may include first phase switch Q1, second phase switch Q3, and third phase switch Q5. Lower phase switches 248 may include first phase switch Q4, second phase switch Q6, and third phase switch Q2. Switches Q1-Q6 may be metal-oxide-semiconductor field-effect transistors (MOSFET), for example, but embodiments are not limited thereto.

Upper phase switches 244 and lower phase switches 248 may be driven by a pulse width modulated (PWM) signal generated by a controller (not shown) to convert DC power delivered via the set of input terminals 285 at bulk capacitor 230 to three phase AC power at outputs U, V, and W (correlating with phases A, B, and C, respectively) via the set of output terminals 295 to motor 190. Additionally, although FIG. 2 depicts a three-phase inverter, the disclosure is not limited thereto, and may include single phase or multi-phase or multi-level inverters.

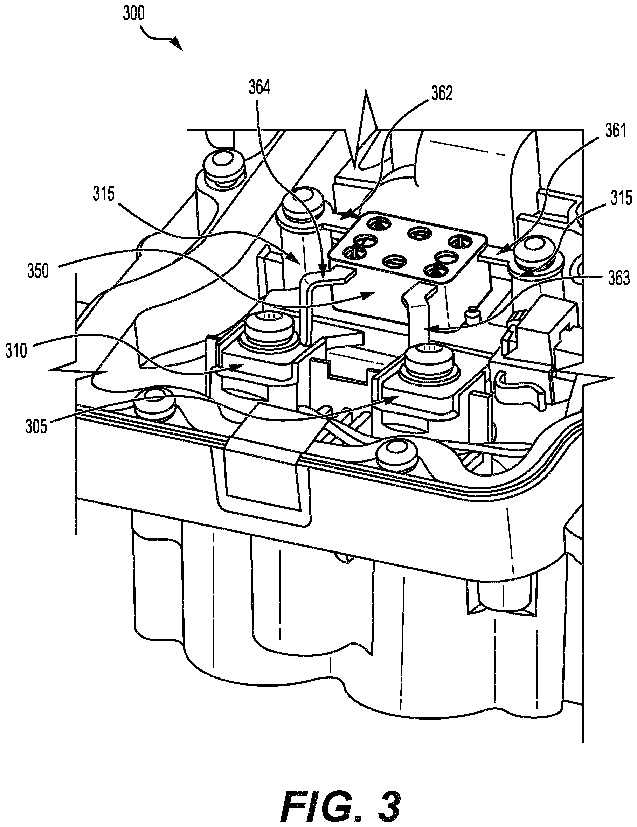

FIG. 3 depicts an exemplary power converter with a capacitor leadframe assembly, according to one or more embodiments. Power converter 300 may correlate with power converter 100, for example. Power converter 300 may include chassis 315, positive connector 305, negative connector 310, and capacitor leadframe 350.

Chassis 315 may be a housing of power converter 300, for example. Chassis 315 may be an electrical ground for one or more of power converter 300, battery 140, or electric vehicle 185. Positive connector 305 may be a connection for a positive terminal of battery 140, for example. Negative connector 310 may be a connection for a negative terminal of battery 140, for example. Capacitor leadframe 350 may include one or more capacitors for power converter 300. The one or more capacitors may suppress differential noise between the positive terminal of battery 140 and negative terminal of battery 140, for example. The one or more capacitors may suppress common mode noise between one or more conductors and ground, for example.

Capacitor leadframe 350 may include one or more leads extending in the outward direction from a carrier of capacitor leadframe 350. For example capacitor leadframe 350 may include a first lead 361 to connect to chassis 315, a second lead 362 to connect to chassis 315, a third lead 363 to connect to positive connector 305, and a fourth lead 364 to connect to negative connector 310. However, the disclosure is not limited to four leads, and capacitor leadframe 350 may include one or more leads, such as three leads, or eight leads, for example.

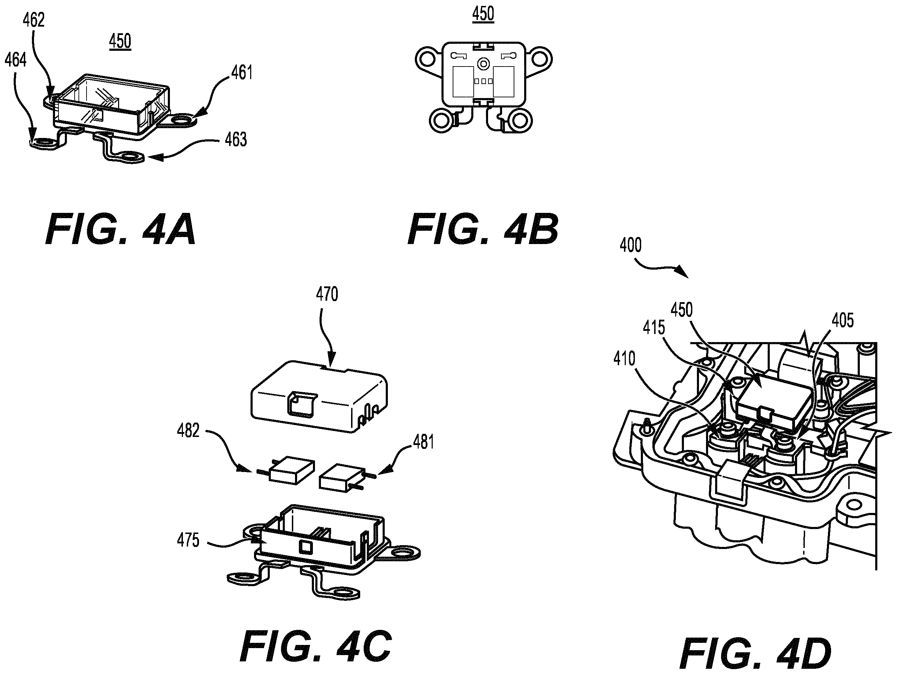

FIG. 4A depicts an isometric view of a capacitor leadframe assembly with a cover, according to one or more embodiments. Capacitor leadframe 450 may correlate with capacitor leadframe 350, for example. As depicted in FIG. 4D, power converter 400 may include chassis 415, positive connector 405, negative connector 410, and capacitor leadframe 450. Capacitor leadframe 450 may include a first lead 461 to connect to chassis 415, a second lead 462 to connect to chassis 415, a third lead 463 to connect to positive connector 405, and a fourth lead 464 to connect to negative connector 410.

FIG. 4B depicts a top view of a capacitor leadframe assembly with a cover, according to one or more embodiments. As depicted in FIG. 4B, first lead 461, second lead 462, third lead 463, and fourth lead 464 may be arranged to be mounted to corresponding terminals of power converter 400. For example, each of first lead 461, second lead 462, third lead 463, and fourth lead 464 may be a ring terminal connector, for example. However, the disclosure is not limited thereto. Each of first lead 461, second lead 462, third lead 463, and fourth lead 464 may be a fork terminal, spade terminal, or other connector type. First lead 461, second lead 462, third lead 463, and fourth lead 464 may all be a same connector type or may be different connector types. For example, first lead 461 and second lead 462 may be ring terminal connectors, and third lead 463 and fourth lead 464 may be spade terminal connectors.

FIG. 4C depicts an exploded view of a capacitor leadframe assembly with a cover, according to one or more embodiments. Capacitor leadframe 450 may include cover 470, carrier 475, first lead 461, second lead 462, third lead 463, and fourth lead 464. Capacitor leadframe 450 may include (or enclose) first capacitor 481 and second capacitor 482. As depicted in FIG. 4C, first capacitor 481 and second capacitor 482 may be mounted horizontally in capacitor leadframe 450. However, the disclosure is not limited thereto.

Capacitor leadframe 450 may include electrical connections (e.g., insulation-displacement technology pin connection) to receive first capacitor 481 and second capacitor 482, and to connect first capacitor 481 and second capacitor 482 to first lead 461, second lead 462, third lead 463, and fourth lead 464 as needed. On or more of carrier 475 or cover 470 may be configured to support the first capacitor 481 and the second capacitor 482 within the carrier 475. The first capacitor 481 and the second capacitor 482 may be disposed between cover 470 and carrier 475. Capacitor leadframe 450 may include physical connections to secure first capacitor 481 and second capacitor 482 in place. The physical connections may be in one or more of cover 470 or carrier 475. Cover 470 may be assembled to carrier 475 using a snap connection, press connection, clamp connection, or other assembly.

FIG. 4D depicts an exemplary power converter with a capacitor leadframe assembly with a cover, according to one or more embodiments. Power converter 400 may include chassis 415, positive connector 405, negative connector 410, and capacitor leadframe 450. Power converter 400 may correlate with power converter 300. Chassis 415, positive connector 405, negative connector 410, and capacitor leadframe 450 may correlate with chassis 315, positive connector 305, negative connector 310, and capacitor leadframe 350, respectively.

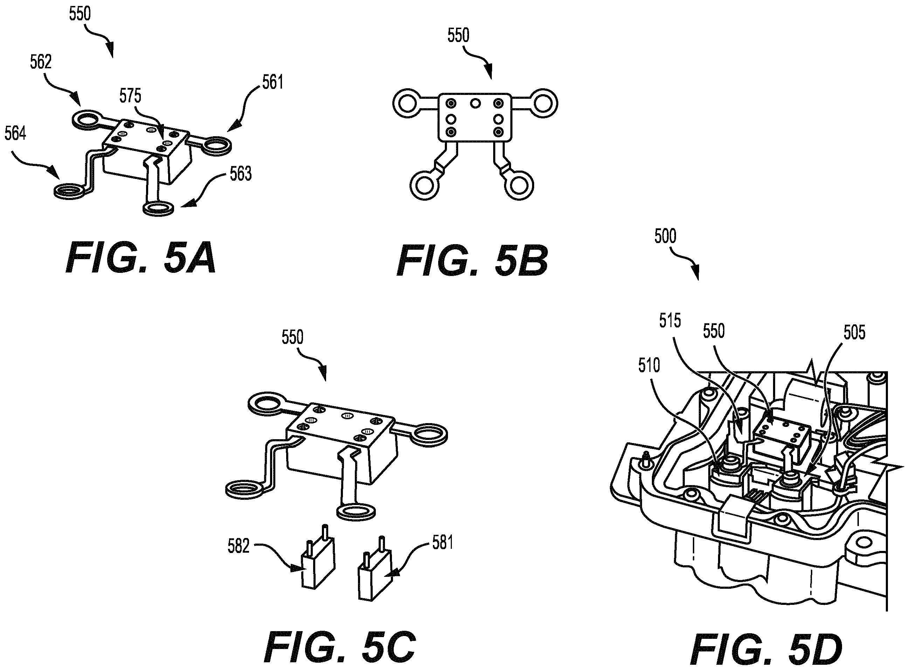

FIG. 5A depicts an isometric view of a soldered capacitor leadframe assembly, according to one or more embodiments. Capacitor leadframe 550 may correlate with capacitor leadframe 350, for example. As depicted in FIG. 5D, power converter 500 may include chassis 515, positive connector 505, negative connector 510, and capacitor leadframe 550. Capacitor leadframe 550 may include a first lead 561 to connect to chassis 515, a second lead 562 to connect to chassis 515, a third lead 563 to connect to positive connector 505, and a fourth lead 564 to connect to negative connector 510.

FIG. 5B depicts a top view of a soldered capacitor leadframe assembly, according to one or more embodiments. As depicted in FIG. 5B, first lead 561, second lead 562, third lead 563, and fourth lead 564 may be arranged to be mounted to corresponding terminals of power converter 500. For example, each of first lead 561, second lead 562, third lead 563, and fourth lead 564 may be a ring terminal connector, for example. However, the disclosure is not limited thereto. Each of first lead 561, second lead 562, third lead 563, and fourth lead 564 may be a fork terminal, spade terminal, or other connector type. First lead 561, second lead 562, third lead 563, and fourth lead 564 may all be a same connector type or may be different connector types. For example, first lead 561 and second lead 562 may be ring terminal connectors, and third lead 563 and fourth lead 564 may be spade terminal connectors.

FIG. 5C depicts an exploded view of a soldered capacitor leadframe assembly, according to one or more embodiments. Capacitor leadframe 550 may include carrier 575, first lead 561, second lead 562, third lead 563, and fourth lead 564. Capacitor leadframe 550 may include (or enclose) first capacitor 581 and second capacitor 582. As depicted in FIG. 5C, first capacitor 581 and second capacitor 582 may be mounted vertically in capacitor leadframe 550. However, the disclosure is not limited thereto.

Capacitor leadframe 550 may include electrical connections (e.g., soldered connections connection) to receive first capacitor 581 and second capacitor 582, and to connect first capacitor 581 and second capacitor 582 to first lead 561, second lead 562, third lead 563, and fourth lead 564 as needed. Capacitor leadframe 550 may include physical connections to secure first capacitor 581 and second capacitor 582 in place.

FIG. 5D depicts an exemplary power converter with a soldered capacitor leadframe assembly, according to one or more embodiments. Power converter 500 may include chassis 515, positive connector 505, negative connector 510, and capacitor leadframe 550. Power converter 500 may correlate with power converter 300. Chassis 515, positive connector 505, negative connector 510, and capacitor leadframe 550 may correlate with chassis 315, positive connector 305, negative connector 310, and capacitor leadframe 350, respectively.

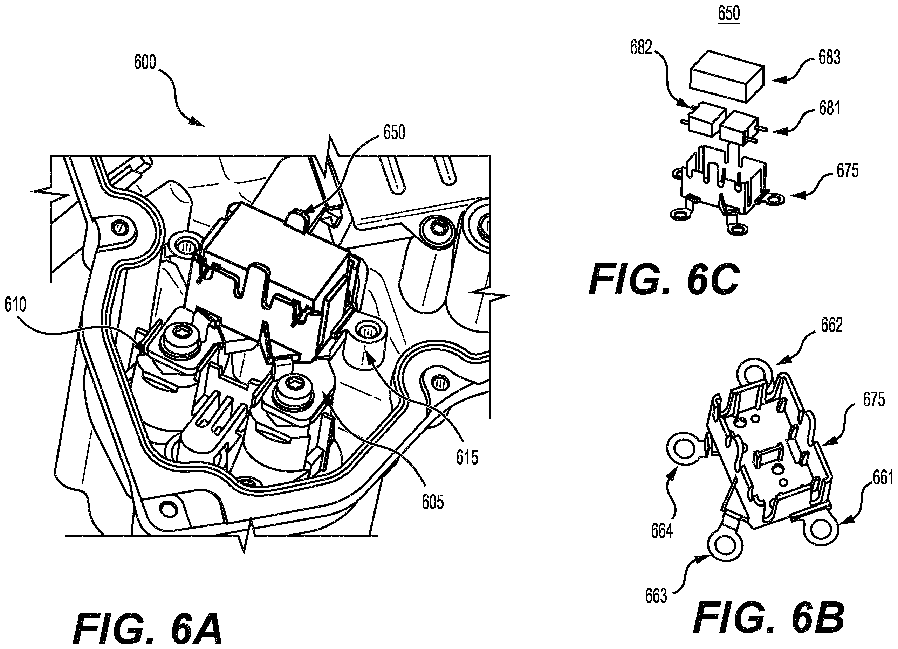

FIG. 6A depicts an exemplary power converter with an XY capacitor leadframe assembly, according to one or more embodiments. Capacitor leadframe 650 may correlate with capacitor leadframe 350, for example. Power converter 600 may include chassis 615, positive connector 605, negative connector 610, and capacitor leadframe 650. Capacitor leadframe 650 may include a first lead 661 to connect to chassis 615, a second lead 662 to connect to chassis 615, a third lead 663 to connect to positive connector 605, and a fourth lead 664 to connect to negative connector 610.

FIG. 6B depicts an XY capacitor leadframe, according to one or more embodiments. As depicted in FIG. 6B, first lead 661, second lead 662, third lead 663, and fourth lead 664 may be arranged to be mounted to corresponding terminals of power converter 600. For example, each of first lead 661, second lead 662, third lead 663, and fourth lead 664 may be a ring terminal connector, for example. However, the disclosure is not limited thereto. Each of first lead 661, second lead 662, third lead 663, and fourth lead 664 may be a fork terminal, spade terminal, or other connector type. First lead 661, second lead 662, third lead 663, and fourth lead 664 may all be a same connector type or may be different connector types. For example, first lead 661 and second lead 662 may be ring terminal connectors, and third lead 663 and fourth lead 664 may be spade terminal connectors.

FIG. 6C depicts an exploded view of an XY capacitor leadframe assembly, according to one or more embodiments. Capacitor leadframe 650 may include carrier 675, first lead 661, second lead 662, third lead 663, and fourth lead 664. Capacitor leadframe 650 may include first capacitor 681, second capacitor 682, and third capacitor 683. As depicted in FIG. 6C, first capacitor 681 and second capacitor 682 may be mounted horizontally in capacitor leadframe 650 between carrier 675 and third capacitor 683. However, the disclosure is not limited thereto.

Capacitor leadframe 650 may include electrical connections (e.g., soldered connections connection) to receive first capacitor 681 and second capacitor 682, and to connect first capacitor 681 and second capacitor 682 to first lead 661, second lead 662, third lead 663, and fourth lead 664 as needed. Capacitor leadframe 650 may include physical connections to secure first capacitor 681, second capacitor 682, and third capacitor 683 in place.

One or more embodiments may lower complexity and component count, which may lower costs associated with using a PCB HVDC filter board, by replacing the HVDC filter board with a capacitor leadframe. A capacitor leadframe may connect the positive and negative HVDC terminals to the chassis inverter ground potential via conductor tracks of a stamped grid, which may be held and fixed by an electrically non-conductive carrier. One or more capacitors may be arranged on the connecting conductor track to be held and fixed in the electrically non-conductive carrier. The electrical connection between the conductor track and the one or more capacitors may be achieved using either soldering or clamping. An advantage may be that the assembled PCB HVDC filter board can be completely replaced by the capacitor leadframe. Additional advantages may include one or more of the following: the use of lower cost Stick Lead capacitors, removing FR4 PCB material, a larger range of capacitors may be used, no soldering may be required using a clamped connection, the assembly process may be simplified at the manufacturing plant, or a cost reduction of the inverter product for the HVDC filter building block. Additional advantages may include flexibility in the number and size of the X and Y capacitors required.

Some inverters may include an HVDC positive terminal, an HVDC negative terminal, an HVDC filter board, and a chassis with ground. The HVDC filter board may connect the HVDC positive and HVDC negative terminals to the chassis with ground. Some HVDC filter boards may include one or more capacitors, a filter board, a resistor, and a filter. One or more embodiments may provide a capacitor leadframe that does not include a filter board, a resistor, or a filter.

One or more embodiments may include a clamped electrical connection. The clamped electrical connection may include an IDT pin connection also serving as an assembly tool. One or more embodiments may include a soldered electrical connection. The soldered electrical connection may include a simplified capacitor leadframe, carrier, and/or soldering of leads.

Other embodiments of the disclosure will be apparent to those skilled in the art from consideration of the specification and practice of the invention disclosed herein. It is intended that the specification and examples be considered as exemplary only, with a true scope and spirit of the invention being indicated by the following claims.

## Claims

1. A system comprising a power converter including:
a capacitor leadframe including:
one or more capacitors;
a carrier supporting the one or more capacitors;
a first lead to connect the one or more capacitors to a first connector;
a second lead to connect the one or more capacitors to a second connector; and
one or more third leads to connect the one or more capacitors to a ground connector.

2. The system of claim 1, wherein the one or more capacitors are configured to filter noise between a positive terminal of a battery and a negative terminal of the battery; and/or wherein the one or more capacitors are configured to filter noise between a conductor and a ground.

3. The system of any one of claims 1 to 2, wherein the first lead, the second lead, and the one or more third leads extend in an outward direction from the carrier;
and/or wherein the first lead, the second lead, and the one or more third leads are connected via one or more of pins, clamps, or solder.

4. The system of any one of claims 1 to 3, wherein the capacitor leadframe further includes a cover.

5. The system of any one of claims 1 to 4, wherein the first connector is for a positive terminal of a power source, and the second connector is for a negative terminal of the power source.

6. The system of any one of claims 1 to 5, further comprising:
a battery configured to provide DC power to the power converter; and
a motor configured to receive AC power from the power converter to drive the motor, wherein the system is provided as a vehicle including the power converter, the battery, and the motor.

7. A capacitor leadframe for a power converter, the capacitor leadframe comprising:
a carrier for one or more capacitors;
a first lead to connect the one or more capacitors to a first connector;
a second lead to connect the one or more capacitors to a second connector; and
one or more third leads to connect the one or more capacitors to a ground connector.

8. The capacitor leadframe of claim 7, wherein the first connector is for a positive terminal of a power source, and the second connector is for a negative terminal of the power source.

9. The capacitor leadframe any one of claims 7 to 8, wherein the capacitor leadframe further includes a cover to connect to the carrier; and
wherein, preferably, one or more of the cover or the carrier are configured to support the one or more capacitors.

10. The capacitor leadframe of any one of claims 7 to 9, wherein the first lead, the second lead, and the one or more third leads extend from the carrier.

11. The capacitor leadframe of any one of claims 7 to 10, wherein the one or more capacitors include one or more first capacitors to suppress noise between the first connector and the second connector, and one or more second capacitors to suppress noise between conductors and the ground connector; and
wherein, preferably, the one or more first capacitors are configured to be arranged between the one or more second capacitors and the carrier.

12. A capacitor leadframe assembly comprising:
one or more capacitors;
a carrier for the one or more capacitors;
a first lead extending from the carrier to electrically connect the one or more capacitors to a first connector;
a second lead extending from the carrier to electrically connect the one or more capacitors to a second connector; and
one or more third leads extending from the carrier to electrically connect the one or more capacitors to a ground connector.

13. The capacitor leadframe assembly of claim 12, further comprising:
a cover connected to the carrier, wherein the one or more capacitors are arranged horizontally in the carrier between the carrier and the cover.

14. The capacitor leadframe assembly of any one of claims 12 to 13, wherein the one or more capacitors are arranged vertically in the carrier.

15. The capacitor leadframe assembly of any one of claims 12 to 14, wherein the one or more capacitors include:
a first capacitor and a second capacitor, the first capacitor and the second capacitor configured to filter common mode noise to the ground connector, and
a third capacitor to filter differential noise between the first connector and the second connector; and
wherein, preferably, the first capacitor and the second capacitor are arranged between the third capacitor and the carrier.
